Europäisches Patentamt

European Patent Office

Office européen des brevets

(19)

(11) Veröffentlichungsnummer: **0 229 898 B1**

(12) **EUROPÄISCHE PATENTSCHRIFT**

(45) Veröffentlichungstag der Patentschrift: 08.01.92

(51) Int. Cl.⁵: **G03B 27/16**

(21) Anmeldenummer: 86115009.2

(22) Anmeldetag: 29.10.86

(54) **Durchlaufbelichtungsgerät.**

(30) Priorität: 17.12.85 DE 3544557

(43) Veröffentlichungstag der Anmeldung:
29.07.87 Patentblatt 87/31

(45) Bekanntmachung des Hinweises auf die
Patenterteilung:
08.01.92 Patentblatt 92/02

(84) Benannte Vertragsstaaten:
AT BE CH DE ES FR GB GR IT LI LU NL SE

(56) Entgegenhaltungen:
DE-A- 2 008 429
DE-A- 2 944 312

(73) Patentinhaber: THEIMER, Siegfried
Rohler Strasse 12
W-6484 Birstein(DE)

(72) Erfinder: THEIMER, Siegfried
Rohler Strasse 12
W-6484 Birstein(DE)

(74) Vertreter: Nix, Frank Arnold, Dr.
Kröckelbergstrasse 15
W-6200 Wiesbaden(DE)

# Beschreibung

Die vorliegende Erfindung bezieht sich auf ein Durchlaufbelichtungsgerät nach dem Oberbegriff des Patentanspruchs. Ein solches Gerät ist aus der DE-A 29 44 312 oder DE-A 2 008 429 bekannt.

Bei diesen Durchlaufbelichtungsgeräten haben die Lichtgitter die Aufgabe, zu verhindern, daß die einzelnen Oberflächenstellen der Kopierpartner, also des Fotomaterials (z. B. eine zu belichtende Druckplatte) und der auf diesem liegenden Belichtungsvorlage (z. B. ein Film) von sehr schräg einfallendem Licht getroffen werden und dadurch Unterstrahlungen auftreten, die die Qualität der Belichtung beeinträchtigen und dazu führen, daß das Bild der Belichtungsvorlage verzerrt oder - im Falle von kleinen Rasterpunkten - gar nicht mehr wiedergegeben wird.

Die bekannten Lichtgitter gewährleisten jedoch keine qualitativ hochwertige Belichtung. Insbesondere werden runde Rasterpunkte der Vorlage zu Ovalen verzerrt, deren Längsachse in Durchlaufrichtung des Kopierguts liegt. Aufgabe der Erfindung ist die Schaffung eines Durchlaufbelichtungsgeräts, bei dem das Lichtgitter so ausgebildet und angeordnet ist, daß eine größere Vorlagentreue der Belichtung erzielt wird.

Die Lösung der gestellten Aufgabe gelingt erfindungsgemäß durch die im kennzeichnenden Teil des Patentanspruchs genannten Merkmale. Diese Merkmale stellen eine Kombination von zusammenwirkenden Maßnahmen dar, die in ihrer Gesamtheit die bisher noch bestehenden Unzulänglichkeiten überraschenderweise beseitigen.

Die Erfindung wird nachfolgend durch die Beschreibung eines Ausführungsbeispiels anhand der beigegebenen Zeichnungen weiter erläutert. Es zeigt:

Fig. 1    schematisch die Anordnung der wesentlichen Elemente eines Durchlaufbelichtungsgeräts;

Fig. 2    die Ansicht des Lichtgitters.

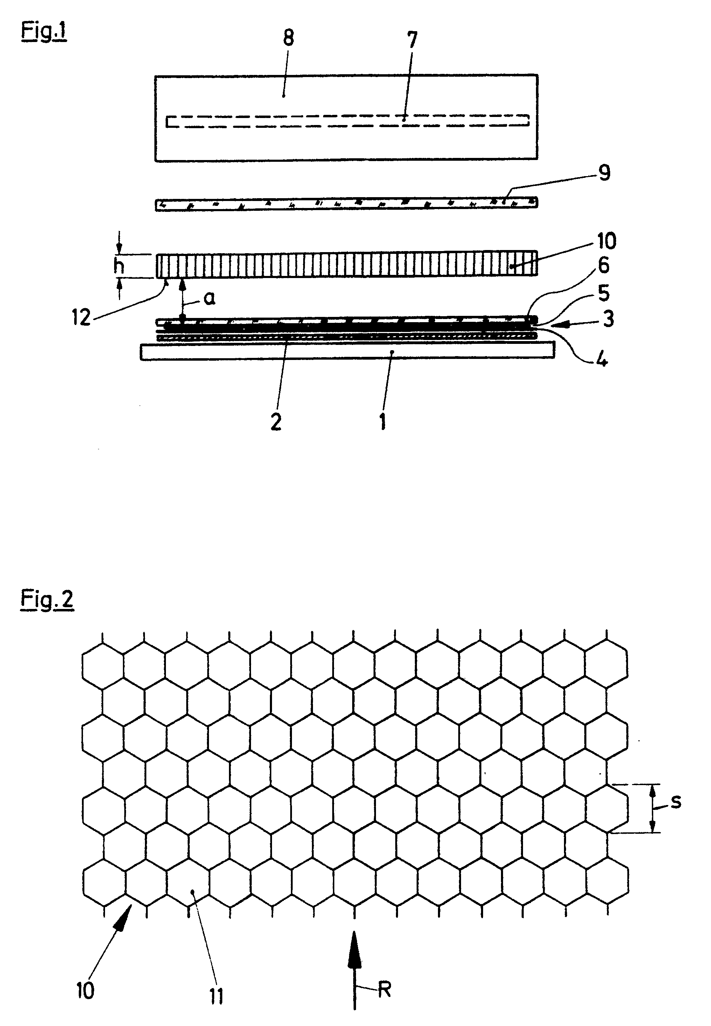

Auf einem Tisch 1 werden auf einem Förderband 2 die Kopierpartner 3, nämlich das Fotomaterial 4 (gewöhnlich eine fotopolymere Druckplatte) und die auf diesem liegende Belichtungsvorlage 5 (in der Regel ein Film) unter einer die Planlage gewährleistenden Glasscheibe 6 hindurchbewegt. Die Bewegungsrichtung gemäß Fig. 1 ist aus der Zeichenebene heraus bzw. in diese hinein.

Oberhalb dieser Anordnung befindet sich eine sich quer zur Durchlaufrichtung erstreckende, nach unten abstrahlende Lichtquelle 7 mit Reflektor 8, und zwischen diesen sind eine weitere Glasplatte 9 und ein Lichtgitter 10 angeordnet.

Das Lichtgitter 10 besteht aus mattschwarzen Blechstreifen, die eine Vielzahl von im Querschnitt, wie in der die Draufsicht zeigenden Fig. 2 ersichtlich, gleichseitigen Sechseck-Zellen 11 bilden, die bienenwabenartig ohne Abstand aneinandergefügt sind. Das Lichtgitter ist so ausgerichtet, daß die Verbindungslinie zwischen zwei einander gegenüberliegenden Ecken mit der Durchlaufrichtung R der Kopierpartner zusammenfällt.

Die Höhe h des Lichtgitters beträgt 10 bis 20 mm, der Abstand a von dessen unterer Lichtaustrittsfläche 12 bis zu den Kopierpartnern 3 beträgt 20 bis 40 mm, und der Abstand s zweier einander gegenüberliegender Ecken jedes Zellen-Sechsecks beträgt 8 bis 15 mm. Die Wandstärke des Materials zwischen den Zellen ist kleiner als 1 mm.

Durch diese Ausbildung des Lichtgitters 10 wird jede Oberflächenstelle der Kopierpartner von im wesentlichen nur rechtwinklig auftreffendem Licht getroffen, so daß Unterstrahlungswirkungen durch Schräglicht praktisch beseitigt sind.

## Patentansprüche

1.  Durchlaufbelichtungsgerät mit einem zwischen der sich quer zur Durchlaufrichtung (R) der Kopierpartner (3), nämlich Fotomaterial (4) und Belichtungsvorlage (5), erstreckenden Lichtquelle (7) und den Kopierpartnern (3) angeordneten Lichtgitter (10) aus einer Vielzahl von in Richtungs des lichtwegs offenen Zellen (11) mit mattschwarzen Kantenflächen,

    dadurch gekennzeichnet, daß das Lichtgitter (10) aus abstandslos aneinandergefügten, im Querschnitt gleichseitigen sechseckigen Zellen (11) besteht, die so ausgerichtet sind, daß die Verbindungslinie zweier einander gegenüberliegender Ecken mit der Durchlaufrichtung (R) der Kopierpartner (3) übereinstimmt, daß der Abstand (a) der der Oberfläche der Kopierpartner (3) zugewandten Lichtaustrittsfläche (12) des Lichtgitters von der Oberfläche der Kopierpartner 20 bis 40 mm beträgt, daß die Höhe (h) des Lichtgitters 10 bis 20 mm beträgt, daß der Abstand (s) gegenüberliegender Spitzen jeder Zelle 8 bis 15 mm beträgt und daß die Wandstärke des die Zellen voneinander trennenden Materials weniger als 1 mm beträgt.

## Claims

1.  A continuous exposure apparatus with a lighting grid (10) of a plurality of cells (11), open in the direction of the path of light, with matt black edge faces, said grid being arranged between the light source (7), extending transverse to the direction of passage (R) of the copying partners (3), namely the photo material (4) and exposure master copy (5), and the copying partners (3),

characterised in that the lighting grid (10) consists of hexagonal cells (11), equal-sided in cross-section, joined to each other without spacing, which are aligned such that the connecting line of two corners facing each other corresponds with the direction of passage (R) of the copying partners (3), in that the distance (a) of the light outlet face (12) of the lighting grid facing the surface of the copying partners (3) from the surface of the copying partners amounts to 20 to 40 mm, in that the height (h) of the lighting grid amounts to 10 to 20 mm, in that the distance (s) between opposing points of each cell amounts to 8 to 15 mm and in that the wall thickness of the material separating the cells from each other is less than 1 mm.

## Revendications

1. Appareil d'exposition en continu comportant un réseau optique (10) constitué d'une multitude de cellules (11) présentant une ouverture au passage de la lumière et des parois noires mates, ledit réseau étant monté entre une source lumineuse (7) et les partenaires photographiques (3), à savoir le matériau photographique (4) et le document à reproduire ou original (5), la source lumineuse (7) s'étendant perpendiculairement à la direction d'avancement (R) des partenaires photographiques (3), caractérisé en ce que le réseau optique (10) est constitué de cellules (11) jointives sans espacement intercalaire, de forme hexagonale en coupe transversale, présentant des côtés égaux, qui sont agencées de façon telle qu'une ligne joignant deux sommets opposes coïncide avec la direction d'avancement (R) des partenaires photographiques (3), que la distance (a) entre le plan de sortie de la lumière (12) tourné vers les partenaires photographiques (3) et la surface des partenaires photographiques est de 20 à 40 mm, que la hauteur (h) du réseau optique est de 10 à 20 mm, que la distance (s) entre les sommets opposés de chaque cellule est de 8 à 15 mm, et que les parois de la matière séparant les cellules ont une épaisseur inférieure à 1 mm.

Fig.1

Fig.2